# EUROPEAN PATENT APPLICATION

(11) **EP 2 503 348 A1**
(43) Date of publication of application: **26.09.2012**
(21) Application number: 11159548.4
(22) Date of filing: 24.03.2011
(51) Int. Cl.: G01R 33/54, G01R 33/561, G01R 33/565, G01R 33/58

(54) **MRI using a multi-point Dixon technique and a low resolution calibration scan**

(71) Applicant: Koninklijke Philips Electronics N.V., 5621 BA Eindhoven (NL)
(72) Inventor: Simonetti, Arjan, W., 5600 AE Eindhoven (NL); Herigault, Gwenael, H., 5600 AE Eindhoven (NL)
(74) Representative: Damen, Daniel Martijn

(57) **Abstract**

The invention relates to a method of MR imaging of at least a portion of a body (10) of a patient positioned in an examination volume of a MR device (1). It is an object of the invention to provide a method that enables improved fat saturation. The method of the invention comprises the steps of:
- subjecting the portion of the body (10) to a calibration sequence comprising RF pulses and switched magnetic field gradients controlled in such a manner that a calibration signal data set is acquired by means of a multi-point Dixon technique at a first image resolution;
- deriving calibration parameters from the calibration signal data set;
- subjecting the portion of the body (10) to an imaging sequence comprising RF pulses and switched magnetic field gradients controlled in such a manner that a diagnostic signal data set is acquired at a second image resolution which is higher than the first image resolution; and
- reconstructing a diagnostic MR image from the diagnostic signal data set,
wherein the MR device (1) is operated according to the derived calibration parameters during acquisition of the diagnostic signal data set and/or during reconstruction of the diagnostic MR image. Moreover, the invention relates to a MR device (1) for carrying out the method and to a computer program to be run on a MR device (1).

## Description

### TECHNICAL FIELD

The invention relates to the field of magnetic resonance (MR) imaging. It concerns a method of MR imaging of at least a portion of a body of a patient positioned in an examination volume of an MR device. The invention also relates to an MR device and to a computer program to be run on an MR device.

### BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for the imaging of soft tissue they are superior to other imaging methods in many respects, do not require ionizing radiation and are usually not invasive.

According to the MR method in general, the body of the patient to be examined is arranged in a strong, uniform magnetic field B₀ whose direction at the same time defines an axis (normally the z-axis) of the co-ordinate system on which the measurement is based. The magnetic field B₀ produces different energy levels for the individual nuclear spins in dependence on the magnetic field strength which can be excited (spin resonance) by application of an electromagnetic alternating field (RF field) of defined frequency (so-called Larmor frequency, or MR frequency). From a macroscopic point of view the distribution of the individual nuclear spins produces an overall magnetization which can be deflected out of the state of equilibrium by application of an electromagnetic pulse of appropriate frequency (RF pulse) while the magnetic field B₀ extends perpendicular to the z-axis, so that the magnetization performs a precessional motion about the z-axis. The precessional motion describes a surface of a cone whose angle of aperture is referred to as flip angle. The magnitude of the flip angle is dependent on the strength and the duration of the applied electromagnetic pulse. In the case of a so-called 90° pulse, the spins are deflected from the z axis to the transverse plane (flip angle 90°).

After termination of the RF pulse, the magnetization relaxes back to the original state of equilibrium, in which the magnetization in the z direction is built up again with a first time constant T₁ (spin lattice or longitudinal relaxation time), and the magnetization in the direction perpendicular to the z direction relaxes with a second time constant T₂ (spin-spin or transverse relaxation time). The variation of the magnetization can be detected by means of receiving RF coils which are arranged and oriented within an examination volume of the MR device in such a manner that the variation of the magnetization is measured in the direction perpendicular to the z-axis. The decay of the transverse magnetization is accompanied, after application of, for example, a 90° pulse, by a transition of the nuclear spins (induced by local magnetic field inhomogeneities) from an ordered state with the same phase to a state in which all phase angles are uniformly distributed (dephasing). The dephasing can be compensated by means of a refocusing pulse (for example a 180° pulse). This produces an echo signal (spin echo) in the receiving coils.

In order to realize spatial resolution in the body, linear magnetic field gradients extending along the three main axes are superposed on the uniform magnetic field B₀, leading to a linear spatial dependency of the spin resonance frequency. The signal picked up in the receiving coils then contains components of different frequencies which can be associated with different locations in the body. The signal data obtained via the receiving coils corresponds to the spatial frequency domain and is called k-space data. The k-space data usually includes multiple lines acquired with different phase encoding. Each line is digitized by collecting a number of samples. A set of k-space data is converted to an MR image by means of Fourier transformation.

With increasing field strength, the off-resonance effects caused by B₀ inhomogeneities become more severe and affect all MR applications. Conventional B₀ shimming methods focus either on a local volume or on a global volume of B₀ inhomogeneities. However, there are MR applications which demand globally constrained B₀ offsets, for example for frequency-selective fat suppression, throughout the field of view (FOV), but also require locally optimal B₀ homogeneity in a region of interest (ROI). An optimal shimming solution for a specific MR application can be achieved by exploiting the higher order shimming coils available in high field MR systems. J. C. Siero et al. (ISMRM 16th Scientific Meeting 2010 Proceedings, p. 2589) have proposed a cost function guided shimming approach that is used at a B₀ field of 3 Tesla for efficient fat suppression in liver and prostate. According to this approach, a trade-off is sought between global and local field homogeneity for the purpose of finding a balance between effective fat suppression and local geometrical distortions. A drawback of this known approach is that no analysis of the target anatomy with regard to the distribution of fat tissue is performed. The known approach differentiates only between the local region of interest and the remaining global field of view. For this reason, no optimal B₀ homogeneity is achieved in the regions containing fat tissue in all cases.

### SUMMARY OF THE INVENTION

From the foregoing it is readily appreciated that there is a need for an improved MR imaging technique. It is consequently an object of the invention to provide a method that enables to increase image quality, notably by achieving a better fat suppression.

In accordance with the invention, a method of MR imaging of at least a portion of a body of a patient positioned in an examination volume of a MR device is disclosed. The method comprises the steps of:
- subjecting the portion of the body to a calibration sequence comprising RF pulses and switched magnetic field gradients controlled in such a manner that a calibration signal data set is acquired by means of a multi-point Dixon technique at a first image resolution;
- deriving calibration parameters from the calibration signal data set;
- subjecting the portion of the body to an imaging sequence comprising RF pulses and switched magnetic field gradients controlled in such a manner that a diagnostic signal data set is acquired at a second image resolution which is higher than the first image resolution; and
- reconstructing a diagnostic MR image from the diagnostic signal data set,
wherein the MR device (1) is operated according to the derived calibration parameters during acquisition of the diagnostic signal data set and/or during reconstruction of the diagnostic MR image.

According to the per se known multi-point Dixon technique, the spectral difference between fat and water spins are made use of for the purpose of separating MR signals emanating from water containing tissue and MR signals emanating from fat tissue. In multi-point Dixon, multiple acquisitions of k-space are repeated with different echo times. The simplest Dixon technique, 2-point Dixon, acquires two complete k-space data sets, wherein the fat magnetization in the second acquisition is out of phase relative to the first acquisition at the respective echo times. Separate and distinct water and fat images are obtained by simple addition or a subtraction of the complex MR signal data sets. However, the original 2-point Dixon technique fails, when B₀ field inhomogeneities become larger. This is the case for many clinical applications at high B₀ fields where global shimming algorithms cannot completely compensate for local field variations. Higher order Dixon techniques such as 3-point Dixon or 4-point Dixon were developed to correct for these field inhomogeneities. In general, a B₀ field map, a water image and a fat image is obtained by means of a multi-point Dixon sequence.

According to the invention, a multi-point Dixon sequence is applied during a low-resolution calibration scan prior to the acquisition of the actual diagnostic image. The advantage is that B₀ mapping using multi-point Dixon is very fast and provides useful information regarding the water and fat distribution within the field of view in addition to the B₀ map that can be exploited for example for deriving shim settings as calibration parameters.

A low-resolution MR image, i.e. an image that is acquired at the first image resolution within the meaning of the invention, is an image, which is, due to the large voxel volume of 10-1000 mm³, not usable for diagnostic purposes. A high-resolution MR image, i.e. a MR image that is acquired at the second image resolution within the meaning of the present invention, is used to answer the respective diagnostic question. The voxel volume of the diagnostic MR image is 10 mm³ or less. Because of the difference in voxel volume, the calibration signal data set can be acquired much faster than the diagnostic signal data set.

According to a preferred embodiment of the invention, the imaging sequence comprises one or more fat suppression RF pulses effecting a spectrally selective suppression of fat signals in the diagnostic signal data set. Since a B₀ map is obtained from the calibration signal data acquired by means of a multi-point Dixon technique in accordance with the invention, the correct frequency and/or bandwidth of the one or more spectrally selective fat suppression RF pulses can be estimated as calibration parameters in a straight forward manner. In the case of image based shimming, a simulated B₀ map (i.e. the B₀ map obtained from the calibration signal data corrected according to the used shim settings) can advantageously be the basis for estimating the frequency and/or bandwidth of the one or more fat suppression RF pulses. The frequency and/or bandwidth of the fat suppression can be determined in such a manner that the number of pixels or voxels within a given region of interest having a B₀ outside the range of spectral selectivity of the one or more fat suppression RF pulses is minimized. In this way, an optimum frequency and bandwidth of the fat suppression can be achieved.

Moreover, the simulated B₀ map can also be used to minimize the amount of undesired water suppression effected by the fat suppression RF pulses due to B₀ inhomogeneity by appropriate selection of the frequency and/or bandwidth of the fat suppression RF pulses. For example, a weighted cost function computed from the number of fat pixels or voxels and from the number of water pixels or voxels affected by the fat suppression RF pulses can be optimized in order maximize image quality. In case water and fat segments are derived from the calibration signal data, the knowledge about the spatial distribution can be taken into account as well for determining the parameters of the fat suppression RF pulses. For example, pixels or voxels that are located within a fat segment can be weighted different than pixels or voxels that are located within a water segment in order to achieve an optimum result.

In multi-slice imaging, the described calibration procedure should be repeated for each slice.

In many applications fat suppression turns out to be difficult, especially in large imaging volumes. This results in regions in the reconstructed MR images having a high image intensity due to failing fat suppression. Fat suppression often fails because the B₀ field is not sufficiently homogeneous to affect all fat spins by the respective frequency selective fat suppression RF pulses. Since a B₀ map, a water map, and a fat map can be obtained from the calibration signal data acquired by means of a multi-point Dixon technique in accordance with the invention, a prediction of pixels or voxels of the diagnostic MR image, in which the spectrally selective suppression of fat signals is incomplete or fails, can be derived. This can be achieved by simply comparing the frequency and bandwidth of the fat suppression RF pulses with the B₀ at the location of a given pixel or voxel. Because the fat and water contribution to the individual pixels or voxels of the diagnostic MR image are known from the fat and water maps, pixels or voxels, for which an incomplete or entirely failing fat suppression is predicted, can be corrected in a post-processing step in order to eliminate the signal contribution from fat. An unwanted suppression of water signals can be processed and corrected for in an analogous manner. A considerable increase of image quality can be achieved in this way by mere post-processing of the reconstructed diagnostic MR image.

According to yet a further preferred embodiment, the method of the invention comprises the steps of:
- reconstructing at least one water image and at least one fat image from the calibration signal data set;
- identifying a water region and a fat region on the basis of the at least one water image and the at least one fat image; and
- determining shim settings that maximize the B₀ homogeneity in the water region and/or in the fat region.

Since the calibration signal data set is acquired in accordance with the invention by means of a multi-point Dixon technique, a water map, a fat map and a B₀ map can be reconstructed from the calibration data, as already mentioned above. These maps are then used for a (preferably automated) segmentation of the water image and the fat image in order to obtain a water region and a fat region. The water region and the fat region are regions within the field of view that contain mainly water and fat tissue respectively. On this basis it is possible to determine shim settings that maximize the B₀ homogeneity (i.e. minimize the B₀ deviations) either in the water region or in the fat region. It is also possible to determine the shim settings in such a manner that a compromise is found that provides a decent B₀ homogeneity in both the water region and the fat region.

According to yet another preferred embodiment of the method of the invention, the shim settings are computed by optimizing a cost function depending on the B₀ deviation within the water region and the fat region. A minimization algorithm can be used to minimize an appropriately set up cost function. Therein the algorithm minimizes the deviation of B₀ in the water region, while simultaneously minimizing the number of voxels within the fat region which deviate more than a given offset value, for example 160 Hz, from the MR resonance frequency. A weighting factor can be applied for differently weighting the water region and the fat region in the cost function. The weighting factor can be selected such that the fat signal within the fat region is sufficiently well suppressed in the final diagnostic image (which is acquired by using frequency selective fat saturation), while the B₀ homogeneity within the water region is sufficiently homogeneous for delivering a diagnostic image of good quality. The parameters resulting from the minimization algorithm can then directly be translated into shim settings for energizing the shimming coils of the MR device.

The method of the invention described thus far can be carried out by means of a MR device including at least one main magnet coil for generating a uniform, steady magnetic field B₀ within an examination volume, a number of gradient coils for generating switched magnetic field gradients in different spatial directions within the examination volume, at least one body RF coil for generating RF pulses within the examination volume and/or for receiving MR signals from a body of a patient positioned in the examination volume, a control unit for controlling the temporal succession of RF pulses and switched magnetic field gradients, a reconstruction unit, and a visualization unit. The method of the invention is implemented by a corresponding programming of the reconstruction unit, the visualization unit and/or the control unit of the MR device.

The method of the invention can be advantageously carried out in most MR devices in clinical use at present. To this end it is merely necessary to utilize a computer program by which the MR device is controlled such that it performs the above-explained method steps of the invention. The computer program may be present either on a data carrier or be present in a data network so as to be downloaded for installation in the control unit of the MR device.

### BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:
Fig. 1 shows a MR device for carrying out the method of the invention;
Fig. 2 shows low-resolution MR images reconstructed from calibration signal data according to the invention;
Fig. 3 shows water and fat regions in a MR image reconstructed from calibration signal data according to the invention.

### DETAILED DESCRIPTION OF THE EMBODIMENTS

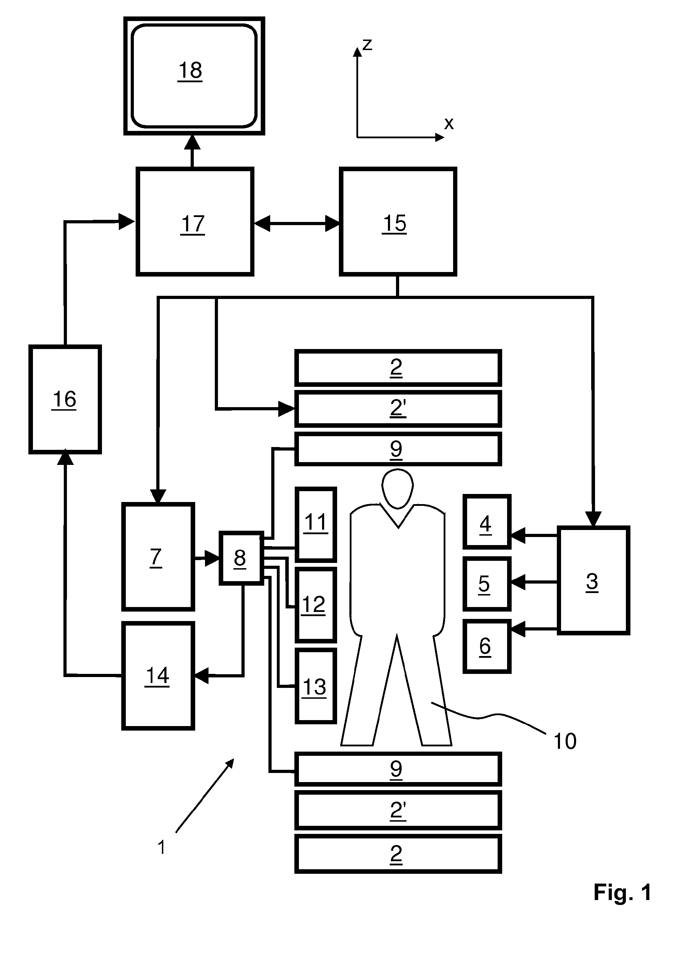

With reference to Figure 1, a MR device 1 is shown. The device comprises superconducting or resistive main magnet coils 2 such that a substantially uniform, temporally constant main magnetic field B₀ is created along a z-axis through an examination volume. The device further comprises a set of (1^{st}, 2^{nd}, and - where applicable - 3^{rd} order) shimming coils 2', wherein the current flow through the individual shimming coils of the set 2' is controllable for the purpose of minimizing B₀ deviations within the examination volume.

A magnetic resonance generation and manipulation system applies a series of RF pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging.

Most specifically, a gradient pulse amplifier 3 applies current pulses to selected ones of whole-body gradient coils 4, 5 and 6 along x, y and z-axes of the examination volume. A digital RF frequency transmitter 7 transmits RF pulses or pulse packets, via a send-/receive switch 8, to a -body RF coil 9 to transmit RF pulses into the examination volume. A typical MR imaging sequence is composed of a packet of RF pulse segments of short duration which taken together with each other and any applied magnetic field gradients achieve a selected manipulation of nuclear magnetic resonance. The RF pulses are used to saturate, excite resonance, invert magnetization, refocus resonance, or manipulate resonance and select a portion of a body 10 positioned in the examination volume. The MR signals are also picked up by the body RF coil 9.

For generation of MR images of limited regions of the body 10 by means of parallel imaging, a set of local array RF coils 11, 12, 13 are placed contiguous to the region selected for imaging. The array coils 11, 12, 13 can be used to receive MR signals induced by body-coil RF transmissions.

The resultant MR signals are picked up by the body RF coil 9 and/or by the array RF coils 11, 12, 13 and demodulated by a receiver 14 preferably including a preamplifier (not shown). The receiver 14 is connected to the RF coils 9, 11, 12 and 13 via send-/receive switch 8.

A host computer 15 controls the shimming coils 2' as well as the gradient pulse amplifier 3 and the transmitter 7 to generate any of a plurality of MR imaging sequences, such as echo planar imaging (EPI), echo volume imaging, gradient and spin echo imaging, fast spin echo imaging, and the like. For the selected sequence, the receiver 14 receives a single or a plurality of MR data lines in rapid succession following each RF excitation pulse. A data acquisition system 16 performs analog-to-digital conversion of the received signals and converts each MR data line to a digital format suitable for further processing. In modem MR devices the data acquisition system 16 is a separate computer which is specialized in acquisition of raw image data.

Ultimately, the digital raw image data is reconstructed into an image representation by a reconstruction processor 17 which applies a Fourier transform or other appropriate reconstruction algorithms, such like SENSE or SMASH. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor 18 which provides a man-readable display of the resultant MR image.

A first practical embodiment of the method of the invention is described as follows:

After positioning the patient 10 in the iso-centre of the main magnet coil 2, a calibration sequence is started as a three-dimensional SENSE reference scan. The calibration scan uses several signal averages performed sequentially in time and is designed in the conventional way with interleaving signal acquisition via the body RF coil 9 and the array RF coils 11, 12, 13 using a Fast Field Echo (FFE) sequence. This sequence is modified into a multi-echo gradient echo sequence generating two or three gradient echoes after one excitation RF pulse, thereby facilitating chemical shift encoding. The calibration sequence is applied at a low image resolution such that the whole calibration scan can be performed within a couple of seconds.

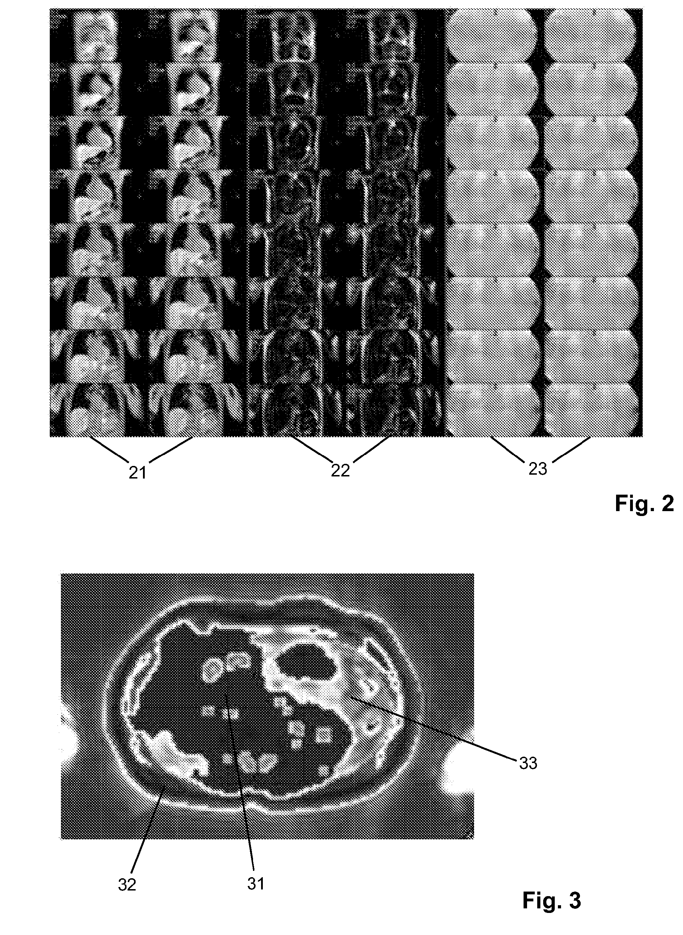

The acquired calibration signal data are then reconstructed corresponding low-resolution images involving a water/fat separation step according to the per se known multi-point Dixon technique. The resulting images are shown in Figure 2. Figure 2 shows the images reconstructed after the water/fat resolved SENSE calibration scan according to the invention. The reconstructed calibration images include water images 20, fat images 21, and B₀ maps 23. Only a subset of the complete calibration data is shown in Figure 2. In the practical embodiment, 64 slices are acquired with a voxel volume of 8x8x12 mm³. A 3-point Dixon technique is applied. The repetition time is 3.5 ms. The low-resolution images reconstructed from the calibration signal data set are transferred to image processing while the acquisition of the next three-dimensional block of calibration signal data is acquired to improve the signal-to-noise ratio or to acquire a different motion state.

Shim settings are derived from the B₀ maps 23, which are used for controlling currents through the shimming coils 2' of the MR device 1 in order to optimize B₀ homogeneity.

After the calibration sequence, an imaging sequence is applied at higher resolution, wherein diagnostic signal data are acquired in parallel via the array RF coils 11, 12, 13. The imaging sequence comprises one or more fat suppression RF pulses effecting a spectrally selective suppression of fat signals in the diagnostic signal data set. For example, a per se known SPAIR technique (spectrally adiabatic inversion recovery) is used for fat suppression. The B₀ maps 23 are used for determining the correct frequency and/or bandwidth of the fat suppression RF pulses. To this end, simulated B₀ maps (i.e. B₀ maps 23 corrected according to the used shim settings) reflecting the 'true' B₀ within the examination volume are computed as a basis for estimating the frequency and bandwidth of the fat suppression RF pulses. The frequency and bandwidth of the fat suppression RF pulses are determined in such a manner that the number of voxels having a B₀ outside the range of spectral selectivity of the fat suppression RF pulses is minimized.

Finally, a diagnostic MR image (not depicted) is reconstructed from the acquired diagnostic signal data set by the reconstruction processor 17 which applies the per se known SENSE reconstruction algorithm.

According to yet another practical embodiment of the invention, again a B₀ map, a water image and a fat image is acquired by means of the calibration sequence at a low image resolution. An automated segmentation is then performed in order to identify regions containing water, regions containing fat tissue and regions containing both water and fat on the basis of the B₀ map, the water map, and the fat map as delivered by the multi-point Dixon technique. Figure 3 shows the result of the segmentation. The water region is designated by reference number 31. The segment 32 represents subcutaneous fat. The region 33 represents a region containing a combination of water and internal fat. On the basis of this segmentation, the shim settings for the shimming coils 2' of the used MR device 1 are computed by optimizing a cost function depending on the B₀ deviation within the regions 31 and 32. It is postulated that in order for the "fat segment" 32 to be suppressed optimally by means of frequency-selective saturation, the number of voxels in the segment 32 with a frequency offset larger than 160 Hz needs to be minimized. It has to be noted that this is an asymmetric criterion since large negative frequency offsets are not relevant. For the "water segment" 31, it is assumed that shimming is sufficient if the number of pixels outside of a frequency offset interval of +-120 Hz is minimized. Both criteria are summed in order to form the cost function. The cost function is minimized by means of an appropriate algorithm. The resulting parameters are then used to derive the shim settings accordingly.

Since a B₀ map, a water map, and a fat map are obtained from the calibration signal data, a prediction of voxels of the diagnostic MR image, in which the fat suppression of fat signals will be incomplete or even fails totally, are derived in accordance with an embodiment of the invention. This is achieved by comparing the frequency and bandwidth of the fat suppression RF pulses with the B₀ at the location of a given voxel. If the local B₀ field is lower or higher than the spectral coverage of the fat suppression RF pulses, fat suppression will fail for the respective voxel. Since the fat and water contribution to the individual voxels are known from the fat and water maps, voxels for which an incomplete or entirely failing fat suppression is predicted are corrected in the final diagnostic MR image in a post-processing step in order to eliminate the signal contribution from fat. To this end, the signal contribution from fat in the respective voxel is derived from the fat map, and the image intensity of the voxel is reduced proportionally. The spectral profile of the fat suppression RF pulses can be taken into account in order to estimate an analogous value reflecting how much the fat suppression will fail for the respective voxel. This value can then be used as a correction factor in order eliminate the fat contribution as precisely as possible. An unwanted suppression of water signal can be processed and corrected for in an analogous fashion. A considerable increase of image quality is achieved in this way by mere post-processing of the reconstructed diagnostic MR image.

## Claims

1. Method of MR imaging of at least a portion of a body (10) of a patient positioned in an examination volume of a MR device (1), the method comprising the steps of:
- subjecting the portion of the body (10) to a calibration sequence comprising RF pulses and switched magnetic field gradients controlled in such a manner that a calibration signal data set is acquired by means of a multi-point Dixon technique at a first image resolution;
- deriving calibration parameters from the calibration signal data set;
- subjecting the portion of the body (10) to an imaging sequence comprising RF pulses and switched magnetic field gradients controlled in such a manner that a diagnostic signal data set is acquired at a second image resolution which is higher than the first image resolution; and
- reconstructing a diagnostic MR image from the diagnostic signal data set,
wherein the MR device (1) is operated according to the derived calibration parameters during acquisition of the diagnostic signal data set and/or during reconstruction of the diagnostic MR image.

2. Method of claim 1, wherein shim settings are derived from the calibration signal data set, which shim settings are used for controlling currents through shimming coils (2') of the MR device (1).

3. Method of claim 1 or 2, wherein the imaging sequence comprises one or more fat suppression RF pulses effecting a spectrally selective suppression of fat signals in the diagnostic signal data set.

4. Method of claim 3, wherein the frequency and/or bandwidth of the one or more spectrally selective fat suppression RF pulses is derived from the calibration signal data set.

5. Method of claim 3 or 4, wherein a simulated B₀ map is derived from the calibration signal data set and from the shim settings, wherein the frequency and/or bandwidth of the one or more fat suppression RF pulses is determined from the simulated B₀ map in such a manner that the number of pixels or voxels within a given region of interest having a B₀ outside the range of spectral selectivity of the one or more fat suppression RF pulses is minimized.

6. Method of any one of claims 3-5, wherein a prediction of pixels or voxels of the diagnostic MR image, in which the spectrally selective suppression of fat signals is incomplete or fails, is derived from the calibration signal data set.

7. Method of claim 6, wherein the diagnostic MR image is corrected in a post-processing step according to the results of the prediction.

8. Method of any one of claims 1-7, further comprising the steps of:
- reconstructing at least one water image (21) and at least one fat image (22) from the calibration signal data set;
- identifying a water region (31) and a fat region (32) on the basis of the at least one water image (21) and the at least one fat image (22); and
- determining shim settings that maximize the B₀ homogeneity in the water region (31) and/or in the fat region (32).

9. Method of claim 8, wherein the shim settings are computed by optimizing a cost function depending on the B₀ deviation within the water region (31) and the fat region (32).

10. MR device for carrying out the method claimed in claims 1-9, which MR device (1) includes at least one main magnet coil (2) for generating a uniform, steady magnetic field B₀ within an examination volume, a number of gradient coils (4, 5, 6) for generating switched magnetic field gradients in different spatial directions within the examination volume, at least one body RF coil (9) for generating RF pulses within the examination volume and/or for receiving MR signals from a body (10) of a patient positioned in the examination volume, a control unit (15) for controlling the temporal succession of RF pulses and switched magnetic field gradients, a reconstruction unit (17), and a visualization unit (18), wherein the MR device (1) is arranged to perform the following steps:
- subjecting the portion of the body (10) to a calibration sequence comprising RF pulses and switched magnetic field gradients controlled in such a manner that a calibration signal data set is acquired by means of a multi-point Dixon technique at a first image resolution;
- deriving calibration parameters from the calibration signal data set;
- subjecting the portion of the body (10) to an imaging sequence comprising RF pulses and switched magnetic field gradients controlled in such a manner that a diagnostic signal data set is acquired at a second image resolution which is higher than the first image resolution; and
- reconstructing a diagnostic MR image from the diagnostic signal data set,
wherein the MR device (1) is operated according to the derived calibration parameters during acquisition of the diagnostic signal data set and/or during reconstruction of the diagnostic MR image.

11. MR device of claim 10, further comprising a number of shimming coils (21) for optimizing the homogeneity of the magnetic field B₀, wherein the MR device (1) is arranged to derive shim settings as calibration parameters from the calibration signal data set and to control the electric current flow through the shimming coils (2') of the MR device (1) according to the derived shim settings.

12. Computer program to be run on a MR device, which computer program comprises instructions for:
- generating a calibration sequence comprising RF pulses and switched magnetic field gradients in such a manner that a calibration signal data set is acquired by means of a multi-point Dixon technique at a first image resolution;
- deriving calibration parameters from the calibration signal data set;
- generating an imaging sequence comprising RF pulses and switched magnetic field gradients in such a manner that a diagnostic signal data set is acquired at a second image resolution which is higher than the first image resolution; and
- reconstructing a diagnostic MR image from the diagnostic signal data set,
wherein the acquisition of the diagnostic signal data set and/or the reconstruction of the diagnostic MR image are performed according to the derived calibration parameters.
